# EUROPEAN PATENT APPLICATION

(11) **EP 4 692 928 A1**
(43) Date of publication of application: **11.02.2026**
(21) Application number: 24780219.2
(22) Date of filing: 25.03.2024
(51) Int. Cl.: G03F 1/62

(54) **PELLICLE MEMBRANE AND PELLICLE**

(30) Priority: 28.03.2023 JP 2023051777
(71) Applicant: LINTEC CORPORATION, Itabashi-ku Tokyo 173-0001 (JP)
(72) Inventor: KUBO Shuhei, Tokyo 173-0001 (JP); KAWAHARA Jun, Tokyo 173-0001 (JP); ICHIKAWA Isao, Tokyo 173-0001 (JP)
(74) Representative: Gille Hrabal Partnerschaftsgesellschaft mbB Patentanwälte
(86) International application number: PCT/JP2024/011769
(87) International publication number: WO 2024/204103

(57) **Abstract**

A pellicle film (10) has a porous structure. The pellicle film (10) includes carbon nanotubes. The average of pore diameters of pores is 60 nm or less, and the average of nearest-neighbor centroid-to-centroid distances between the pores is 70 nm or less, the averages being measured at a surface of the porous structure.

## Description

### TECHNICAL FIELD

The present invention relates to a pellicle film and a pellicle.

### BACKGROUND ART

In a process of manufacturing a semiconductor device or the like, for example, a photoresist is applied to a substrate such as a semiconductor wafer, the substrate coated with the photoresist is irradiated with light using a photomask, and the photoresist is removed, whereby a desired circuit pattern is formed on the substrate.

If light is applied in a state where foreign matter adheres to the photomask, the adhering foreign matter may adversely affect the circuit pattern formed on the substrate. For this reason, to inhibit adhesion of foreign matter to the photomask, a pellicle including a pellicle film for capturing foreign matter is occasionally used. The pellicle is disposed above the photomask at a distance such that the pellicle film is not in contact with the photomask.

In recent years, use of extreme ultra violet (EUV) has been studied in order to form a finer circuit pattern. EUV refers to light with a wavelength in a range from 1 nm to 100 nm. For example, specifically, a light beam with a wavelength of about 13.5 nm ± 0.3 nm is being used as EUV. When EUV is applied to a pellicle film, the EUV passes through the pellicle film, but the applied EUV is partially absorbed by the pellicle film. The light energy of the absorbed EUV is converted into thermal energy, whereby the temperature of the pellicle film is increased. Thus, the pellicle film is required to have, for example, EUV transmissivity, heat resistance, and durability.

In a pellicle used in a step of forming a circuit pattern using EUV, carbon nanotubes have been studied as one of the materials used for a pellicle film included in the pellicle.

For example, Patent Literature 1 discloses a pellicle film that includes, at least on its surface layer side, carbon nanotubes having a silicon carbide layer in which at least some carbon atoms are replaced with silicon atoms.

### CITATION LIST

### PATENT LITERATURE(S)

Patent Literature 1: International Publication No. WO 2021/172104

### SUMMARY OF THE INVENTION

### PROBLEM(S) TO BE SOLVED BY THE INVENTION

The pellicle film including carbon nanotubes disclosed in Patent Literature 1 is described as having high strength and high EUV transmissivity. However, there is no mention of the pellicle film disclosed in Patent Literature 1 regarding pore characteristics in a surface of the pellicle film. Pore characteristics are likely to affect foreign matter capturing performance and EUV transmissivity. For example, if a pore structure such as a pore diameter and an average of nearest-neighbor centroid-to-centroid distances between pores is excessively enlarged to improve EUV transmissivity, the foreign matter capturing performance will decrease. The pellicle film is thus required to ensure high EUV transmissivity while downsizing the pore structure.

An object of the invention is to provide a pellicle film including carbon nanotubes, the pellicle film ensuring EUV transmissivity even when the pellicle film has a reduced-size pore structure, and a pellicle including the pellicle film.

### MEANS FOR SOLVING THE PROBLEM(S)

[1] A pellicle film having a porous structure, in which the pellicle film includes carbon nanotubes, and an average of pore diameters of pores is 60 nm or less, and an average of nearest-neighbor centroid-to-centroid distances between the pores is 70 nm or less, the averages being measured at a surface of the porous structure.
[2] The pellicle film according to [1], in which the average of pore diameters is in a range from 20 nm to 60 nm.
[3] The pellicle film according to [1] or [2], in which the average of nearest-neighbor centroid-to-centroid distances is in a range from 40 nm to 70 nm.
[4] The pellicle film according to any one of [1] to [3], in which the carbon nanotubes have a length in a range from 0.1 µm to 1000 µm.
[5] The pellicle film according to any one of [1] to [4], in which the carbon nanotubes have a cross-sectional diameter in a range from 0.2 nm to 50 nm.
[6] The pellicle film according to any one of [1] to [5], in which the pellicle film is a porous structural body formed by deposition of the carbon nanotubes.
[7] The pellicle film according to any one of [1] to [6], in which the pellicle film has a self-standing property.
[8] A pellicle including: the pellicle film according to any one of [1] to [7]; and a support that has a frame and an opening surrounded by the frame and that supports the pellicle film.

According to an aspect of the invention, a pellicle film including carbon nanotubes, the pellicle film ensuring EUV transmissivity even when the pellicle film has a reduced-size pore structure, and a pellicle including the pellicle film can be provided.

### BRIEF DESCRIPTION OF DRAWINGS

Fig. 1 is a plan view schematically illustrating an example of a pellicle according to an exemplary embodiment.
Fig. 2 is a sectional view taken along line II-II in Fig. 1.

### DESCRIPTION OF EMBODIMENT(S)

### Pellicle Film

A pellicle film according to an exemplary embodiment has a porous structure. The pellicle film includes carbon nanotubes, the average of pore diameters of pores is 60 nm or less, and the average of nearest-neighbor centroid-to-centroid distances between pores is 70 nm or less, the averages being measured at a surface of the porous structure.

The pellicle film having the above-described configuration according to the exemplary embodiment is considered to have a large number of relatively small pores, and therefore can be regarded to have a reduced-size pore structure. It is assumed that, although the pore structure of the pellicle film according to the exemplary embodiment has a reduced size, a large number of relatively small pores allow for EUV transmissivity. In addition, the pellicle film according to the exemplary embodiment has a reduced-size pore structure, and therefore also improves foreign matter capturing performance while ensuring EUV transmissivity.

The reduced-size pore structure of the pellicle film according to the exemplary embodiment is considered to have a certain size, and therefore it is considered that transmissivity of the light transmitted through the pellicle film is ensured and the foreign matter capturing performance is improved. Examples of the pore structure having a certain size include a pore structure in which the average of pore diameters is 20nm or more. Examples of the pore structure having a certain size include a pore structure in which the average of nearest-neighbor centroid-to-centroid distances is 40 nm or more.

The means for adjustment to a pellicle film in which the average of pore diameters of pores is 60 nm or less, and the average of nearest-neighbor centroid-to-centroid distances between pores is 70 nm or less, the averages being measured at a surface of the porous structure, is not particularly limited. One example of the means is adjusting, in an example of a preferred method for producing a pellicle film described later, the amount of carbon nanotubes included in the pellicle film (e.g., the amount of carbon nanotubes contained in a carbon nanotube film product which is an intermediate product in forming the pellicle film, or the amount of carbon nanotubes in a carbon nanotube dispersion in forming the carbon nanotube film product) and the intensity in dispersing the carbon nanotubes.

The carbon nanotubes included in the pellicle film according to the exemplary embodiment are not particularly limited and are preferably at least one selected from the group consisting of multi-walled carbon nanotubes (MWCNT), few-walled carbon nanotubes (FWCNT), double-walled carbon nanotubes (DWCNT), and single-walled carbon nanotube (SWCNTS).

The carbon nanotubes are obtained by, for example, a known production method such as an arc discharge method, a laser ablation method, or chemical vapor deposition.

For example, the length of the carbon nanotubes is preferably in a range from 0.1 µm to 1000 µm.

The length of the carbon nanotubes is more preferably 0.5 µm or more, still more preferably 1 µm or more.

The length of the carbon nanotubes is more preferably 600 µm or less, still more preferably 400 µm or less.

The cross-sectional diameter of the carbon nanotubes is preferably in a range from 0.2 nm to 50 nm.

The cross-sectional diameter of the carbon nanotubes is more preferably 0.5 nm or more, still more preferably 1 nm or more.

The cross-sectional diameter of the carbon nanotubes is more preferably 30 nm or less, still more preferably 20 nm or less.

Herein, a cross-sectional diameter may be referred to simply as a diameter.

In order to easily ensure EUV transmissivity, the average of pore diameters of pores measured at a surface of the porous structure of the pellicle film may be, for example, in a range from 20 nm to 60 nm. The average of pore diameters may be 25 nm or more, or may be 30 nm or more. The average of pore diameters may be 55 nm or less, or may be 50 nm or less.

Herein, a pore diameter means a diameter of an imaginary circle having the same area as the area of a pore (i.e., an equivalent circle diameter).

In order to easily ensure EUV transmissivity, the average of nearest-neighbor centroid-to-centroid distances between pores measured at a surface of the porous structure of the pellicle film is preferably, for example, in a range from 40 nm to 70 nm. The average of nearest-neighbor centroid-to-centroid distances between pores may be 45 nm or more, or may be 50 nm or more. The average of nearest-neighbor centroid-to-centroid distances between pores may be 68 nm or less, or may be 67 nm or less.

Herein, a nearest-neighbor centroid-to-centroid distance between pores is the distance between the centroid of one pore and the centroid of a pore most closely adjacent to the one pore. That is, it means the distance from the centroid of one pore to the centroid of another pore, the pores being adjacent to each other.

That is, in the pellicle film according to the exemplary embodiment, the average of pore diameters of pores may be in a range from 20 nm to 60 nm and the average of nearest-neighbor centroid-to-centroid distances between pores may be in a range from 40 nm to 70 nm, the averages being measured at a surface of the porous structure.

Regarding the pore characteristics measured at a surface of the porous structure of the pellicle film, the average of pore diameters and the average of nearest-neighbor centroid-to-centroid distances between pores may be measured by a method including the following steps (1) to (10). Since a unique threshold is determined by adopting the following measurement method, for example, plausible results are likely to be obtained irrespective of the measurer. The method of measuring the pore characteristics is, specifically, as described in Examples given later.
(1) A step of providing a pellicle film.
(2) A step of capturing an image of a surface of the provided pellicle film to acquire image data of the pellicle film.
(3) A step of setting a plurality of different thresholds of three or more as initial thresholds at equal intervals in a range from a first pixel value to a second pixel value larger than the first pixel value and performing binarization processing on the image data on the basis of each of the initial thresholds to acquire binarized image data based on the initial thresholds.
(4) A step of performing blob analysis on the binarized image data based on the initial thresholds to thereby obtain an initial actual value calculated as a distribution of pore characteristics of pores in the surface of the pellicle film.
(5) A step of determining, on the basis of the initial actual value, an initial theoretical value of the distribution of pore characteristics that is determined from a probability density function of a lognormal distribution.
(6) A step of determining a difference between the initial actual value and the initial theoretical value.
(7) A step, in the case where the difference between the initial actual value and the initial theoretical value is not minimal, of resetting a threshold, performing binarization processing on the image data on the basis of the reset threshold to acquire binarized image data based on the reset threshold, and performing blob analysis on the binarized image data based on the reset threshold to thereby obtain a remeasured actual value calculated as a distribution of pore characteristics of pores in the surface of the pellicle film.
(8) A step of determining, on the basis of the remeasured actual value, a difference from a remeasured theoretical value of the distribution of pore characteristics that is determined from a probability density function of a lognormal distribution.
(9) A step, in the case where the difference between the remeasured actual value and the remeasured theoretical value is not minimal, of repeating the step of obtaining a remeasured actual value and the step of determining a difference from a remeasured theoretical value until the difference between the remeasured actual value and the remeasured theoretical value becomes minimal.
(10) A step of obtaining, as a final actual value, a distribution of pore characteristics calculated on the basis of a threshold at which the difference between the initial actual value and the initial theoretical value or the difference between the remeasured actual value and the remeasured theoretical value is minimal.

The threshold at which the difference is minimal is preferably determined by using various known optimization algorithms. For example, it is preferable that a threshold at which the above-described difference is minimal is searched out using various known optimization algorithms in the above steps (4) to (9). In this case, after the initial thresholds are determined, the unique threshold is determined by using the optimization algorithms.

In the step of obtaining binarized image data based on the initial thresholds, the initial thresholds are not limited to those described above, and a plurality of different thresholds of five or more may be set at equal intervals in a range from a first pixel value to a second pixel value larger than the first pixel value, or a plurality of different thresholds of seven or more may be set. The interval between the first pixel value and the second pixel value is preferably 100 or more. The first pixel value is preferably set in a range from 20 to 50. The second pixel value is preferably set in a range from 150 to 240. Equal intervals mean that intervals between adjacent thresholds are equal: for example, when n thresholds are set as the plurality of different thresholds of three or more, the interval between the n-th threshold and the (n - 1)th threshold and the interval between the (n - 1)th threshold and the (n - 2)th threshold are equal. As the initial thresholds, specifically, for example, a plurality of different thresholds in a range from 3 to 12 can be set at equal intervals in a range from a pixel value of 20 to a pixel value of 240.

In the step of obtaining a remeasured actual value, the threshold to be reset is not the plurality of different thresholds of three or more but one threshold.

The pore characteristics may be measured with, for example, an apparatus including a program for causing a computer to execute the above steps (1) to (10). The program may be recorded on a recording medium.

The thickness of the pellicle film is preferably in a range from 3 nm to 1000 nm. The thickness of the pellicle film is preferably 10 nm or more, more preferably 20 nm or more. The thickness of the pellicle film is preferably 500 nm or less, more preferably 300 nm or less. When the thickness of the pellicle film is, for example, in a range from 3 nm to 1000 nm, EUV transmissivity is ensured more easily. In addition, the operability of the pellicle film improves.

The weight of the pellicle film per unit area is not particularly limited and is, for example, preferably in a range from 0.1 µg/cm² to 20 µg/cm². The weight of the pellicle film per unit area is more preferably 0.5 µg/cm² or more, still more preferably 1 µg/cm² or more. The weight of the pellicle film per unit area is more preferably 15 µg/cm² or less, still more preferably 10 µg/cm² or less. When the weight of the pellicle film per unit area is, for example, in a range from 0.1 µg/cm² to 20 µg/cm², EUV transmissivity is ensured more easily.

The pellicle film according to the exemplary embodiment is preferably a porous structural body formed by deposition of the carbon nanotubes. The porous structural body formed by deposition of the carbon nanotubes can be produced by an example of a preferred method for producing a pellicle film described later. When the pellicle film is a porous structural body formed by deposition of the carbon nanotubes, EUV transmissivity is ensured more easily.

From the viewpoint of improving transparency to exposure light, the pellicle film according to the exemplary embodiment preferably has a self-standing property. The pellicle film having a self-standing property means a pellicle film that is self-standing on its own and means that the pellicle film is a film having a self-supporting property (also referred to as a self-standing film). That is, the pellicle film having a self-standing property is a pellicle film that can retain its shape by itself even in the absence of a substrate or the like.

### Method for Producing Pellicle Film

The method for producing a pellicle film is not particularly limited. An example of a preferred method for producing a pellicle film includes, for example, a step of dispersing carbon nanotubes (P1), a step of precipitating and depositing the dispersed carbon nanotubes on an air-permeable member to obtain a carbon nanotube film product formed in mat form on the air-permeable member (P2), and a step of removing the air-permeable member from the carbon nanotube film product to obtain a pellicle film (P3).

First, in Step P1, carbon nanotubes are dispersed in a liquid serving as a dispersion medium to prepare a carbon nanotube dispersion in which the carbon nanotubes are dispersed in the liquid. The liquid may be a liquid containing water. The carbon nanotube dispersion may contain only the carbon nanotubes as a dispersoid. The carbon nanotube dispersion may contain, in addition to the carbon nanotubes, various additives such as a dispersant for dispersing the carbon nanotubes.

For example, adjusting the balance between the dispersion intensity in dispersing the carbon nanotubes in the liquid in Step P1 and the weight of the carbon nanotubes per unit area in producing a carbon nanotube film product in Step P2 helps provide a pellicle film in which the average of pore diameters is 60 nm or less and the average of nearest-neighbor centroid-to-centroid distances between pores is 70 nm or less. For example, specifically, when the weight of the carbon nanotubes per unit area is a certain amount or more, the average of pore diameters is likely to satisfy the range of 60 nm or less, and when the weight of the carbon nanotubes per unit area is excessively reduced, the average of pore diameters tends to exceed 60 nm. For example, when the dispersion intensity is kept within a certain range, the average of nearest-neighbor centroid-to-centroid distances between pores is likely to satisfy the range of 70 nm or less, and when the dispersion intensity is excessively increased, the average of nearest-neighbor centroid-to-centroid distances between pores tends to exceed 70 nm.

Regarding the weight of the carbon nanotubes per unit area and the dispersion intensity, the amount of the carbon nanotubes contained in the carbon nanotube film product produced in Step P2 may be, for example, in a range from 0.1 µg/cm² to 20 µg/cm². Regarding the dispersion intensity, when a stirrer is used as a disperser for dispersing the carbon nanotubes, the peripheral speed of the stirrer may be, for example, in a range from 10 m/s to 60 m/s, and the duration of stirring with the stirrer may be, for example, in a range from 5 minutes to 60 minutes.

Next, in Step P2, the dispersed carbon nanotubes are precipitated and deposited on an air-permeable member. For example, the carbon nanotube dispersion prepared in Step P1 is filtered through a filtration membrane serving as an air-permeable member, so that the carbon nanotubes are precipitated and deposited to form a carbon nanotube film product formed in mat form on the filtration membrane. As the filtration membrane, for example, a membrane filter or the like is preferably used.

Next, in Step P3, the filtration membrane is removed from the carbon nanotube film product formed in mat form, whereby a pellicle film including carbon nanotubes is obtained. Before the filtration membrane is removed from the fiber film product formed in mat form, or after the filtration membrane is removed from the fiber film product formed in mat form, a drying step may be provided as necessary. The obtained pellicle film is a self-standing film.

### Pellicle

A pellicle according to an exemplary embodiment includes the pellicle film according to the exemplary embodiment described above and a support that has a frame and an opening surrounded by the frame and that supports the pellicle film.

Hereinafter, the pellicle according to the exemplary embodiment will be described with reference to the drawings.

It should be noted that in drawings for description with reference to the drawings in this specification, some portions are illustrated in enlarged or reduced size for simplicity of explanation.

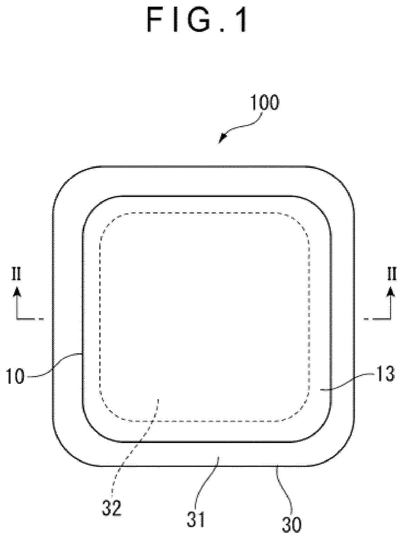

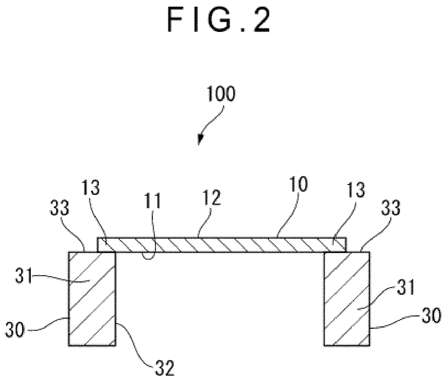

Fig. 1 is a plan view of a pellicle 100 as viewed in plan from a side on which a pellicle film 10 is disposed, and Fig. 2 is a sectional view of the pellicle 100 illustrated in Fig. 1. The pellicle 100 includes the pellicle film 10 and a support 30 that supports the pellicle film 10. The support 30 has a frame 31 and an opening 32 surrounded by the frame 31, and the opening 32 passes through the support 30 from one surface to the other surface. The frame 31 and the opening 32 are each formed in a rectangular shape, and all four corners of the outer contour of the frame 31 are rounded. The frame 31 has a support surface 33 that faces the pellicle film 10. The pellicle film 10 is formed in a rectangular shape and has a first pellicle film surface 11 that faces the support surface 33 of the support 30 and a second pellicle film surface 12 opposite to the first pellicle film surface 11. The pellicle film 10 covers the opening 32 of the support 30 such that a peripheral portion 13 of the pellicle film 10 is fixed to a portion of the support surface 33 of the frame 31.

The above-described pellicle film according to the exemplary embodiment is used as the pellicle film 10. Examples of the material of the support 30 include resin materials (e.g., polyethylene), metal materials (e.g., aluminum, aluminum alloys, magnesium alloys, stainless steel, and titanium), ceramic materials (e.g., SiC), and fiber-reinforced plastic materials (e.g., carbon fiber-reinforced plastics).

For the pellicle film 10, to clarify the positional relationship between a surface facing the support surface 33 of the support 30 and the opposite surface, the terms "first pellicle film surface 11" and "second pellicle film surface 12" are used for convenience. Therefore, in some cases, the first pellicle film surface 11 and the second pellicle film surface 12 can be interchangeably used, and the first pellicle film surface 11 and the second pellicle film surface 12 can be used without distinction.

Although an example of the pellicle according to the exemplary embodiment has been described above with reference to Fig. 1 and Fig. 2, the pellicle according to the exemplary embodiment is not limited thereto. The pellicle according to the exemplary embodiment may employ any form as long as the advantageous effects of the pellicle including the above-described pellicle film according to the exemplary embodiment are obtained. The shape, dimensions, etc. of portions of members constituting the pellicle according to the exemplary embodiment can be determined according to, for example, the dimensions of a photomask (not illustrated) for which the pellicle according to the exemplary embodiment is used.

For example, the pellicle film 10 and the support 30 of the pellicle 100 illustrated in Fig. 1 and Fig. 2 are each formed in a rectangular shape. The pellicle according to the exemplary embodiment is not limited thereto and may be formed in any desired shape such as a circular, elliptical, or polygonal shape.

For example, in the pellicle 100 illustrated in Fig. 1 and Fig. 2, the peripheral portion 13 of the pellicle film 10 is fixed to a portion of the support surface 33 of the support 30. The pellicle 100 is not limited thereto, and the peripheral portion 13 of the pellicle film 10 may be fixed to the entire surface of the support surface 33 of the support.

For example, in Fig. 1 and Fig. 2, the pellicle film 10 and the support 30 may be fixed together by providing a bonding layer (not illustrated). The bonding layer is a layer provided as necessary. Examples of materials constituting the bonding layer that may be used include, but are not limited to, various adhesives such as acrylic resins, epoxy resins, silicone resins, polyimide resins, and fluorocarbon resins, and carbon nanotubes.

### Method for Producing Pellicle

An example of a preferred method for producing a pellicle according to an exemplary embodiment includes a step of preparing a pellicle film according to an exemplary embodiment, a step of preparing a support that has a frame and an opening surrounded by the frame and that supports the pellicle film, and a step of providing the pellicle film on the support such that the pellicle film covers the opening and is supported by a support surface of the frame. This production method may optionally include a step of providing a bonding layer on at least a portion of the support surface of the frame.

The step of preparing a pellicle film according to an exemplary embodiment only has to prepare the pellicle film according to the above exemplary embodiment. The step of preparing a support only has to prepare a support formed in a desired shape by a known method using any of the above-described materials for the support. The step of providing the pellicle film only has to dispose the pellicle film by a known method such that the pellicle film covers the opening and is supported by the support surface of the frame. When a bonding layer is provided on at least a portion of the support surface of the frame, the pellicle film is disposed so as to be supported by the support surface of the frame with the bonding layer therebetween. In the step of providing a bonding layer where an adhesive is used for the bonding layer, the adhesive is applied to the support surface to thereby provide the bonding layer including the adhesive. In the step of providing a bonding layer where carbon nanotubes are used for the bonding layer, for example, a carbon nanotube dispersion is applied to the support surface and dried to thereby provide the bonding layer including the carbon nanotubes.

The pellicle according to the exemplary embodiment is used, for example, while being disposed above a photomask so as to be spaced from the photomask such that the first pellicle film surface faces the photomask. Use of the pellicle according to the exemplary embodiment ensures EUV transmissivity. In addition, the pellicle film having a reduced-size pore structure according to the exemplary embodiment has improved foreign matter capturing performance and is more effective in inhibiting adhesion of foreign matter to a photomask.

The invention is not limited to the above exemplary embodiment(s) and includes any modification, improvement, and the like as long as the object of the invention can be achieved.

### Examples

The invention will now be described in more detail with reference to Examples, but these Examples are not intended to limit the invention.

### Example 1

### Preparation of Pellicle Film

As carbon nanotubes (hereinafter referred to as CNTs), CNTs having a diameter in a range from 0.2 nm to 50 nm and a length in a range from 1 µm to 250 µm were provided. The provided CNTs were weighed such that the concentration of the CNTs in a water dispersion would be 0.02 mass%. Carboxymethyl cellulose (hereinafter referred to as CMC) as a dispersant was weighed such that its concentration in the water dispersion would be 0.2 mass%. The weighed CNTs and the weighed CMC were put into water, and using a thin-film spin-system high-speed stirrer (manufactured by PRIMIX Corporation, product name "FILMIX"), the CNTs were dispersed in water at a peripheral speed of 40 m/s for a dispersion time of 25 minutes to prepare an aqueous CNT dispersion. The shear rate at which the CNTs were dispersed was about 4.0 × 10⁵ s⁻¹. The aqueous CNT dispersion was then diluted to a CNT concentration of 1 ppm. The diluted aqueous CNT dispersion was then put into a filtration device such that the mass of the CNTs included in a pellicle film (denoted as Mass of CNT in film in Table 1) would be 0.71 µg/cm². The aqueous CNT dispersion put in the filtration device was then filtered through a membrane filter to form a CNT film product in mat form on the membrane filter. Thereafter, the CNT film product in mat form was peeled off from the membrane filter to prepare a pellicle film including the CNTs. The pellicle film was a film having a self-standing property. On the basis of the pellicle film obtained, the average of pore diameters and the average of nearest-neighbor centroid-to-centroid distances between pores were calculated in accordance with Pore Analysis of Pellicle Film described below.

### Pore Analysis of Pellicle Film

A surface of the pellicle film obtained in each Example was observed with a scanning electron microscope (SEM) (CrossBeam 550 manufactured by Carl Zeiss) to acquire SEM image data. The imaging was performed at an acceleration voltage of 1 kV and a magnification of 10,000× in three or more fields of view.

On the basis of the SEM image data obtained, pore diameters (pore sizes) were analyzed as equivalent circle diameters. First, in one field of view of the SEM image data, seven initial binarization thresholds were set between a pixel value of 40 and a pixel value of 160 at equal intervals of 20 pixel values, i.e., at 40, 60, 80, 100, 120, 140, and 160, and seven binarized image data were obtained at these binarization thresholds. This operation was performed on the image data of the three or more fields of view. Next, using the binarized image data obtained, the initial distribution of pore diameters based on the initial binarization thresholds was measured. Thereafter, fitting was performed using Bayesian optimization such that the actual value of the distribution of pore diameters closely approximated (fitted) the lognormal distribution, thereby automatically searching out binarization thresholds that minimized the difference between the actual value of the distribution of pore diameters and the theoretical value of the distribution of pore diameters. From the distribution of pore diameters and the distribution of nearest-neighbor centroid-to-centroid distances between pores measured on the basis of the binarization thresholds at which the difference between the actual value of the distribution of pore diameters and the theoretical value of the distribution of pore diameters was minimized, the average of pore diameters and the average of nearest-neighbor centroid-to-centroid distances between pores were calculated.

### Evaluation of Transmissivity at Wavelength of 550 nm

For the pellicle obtained in each Example, the light transmittance in the wavelength range from 200 nm to 800 nm was measured using an ultraviolet-visible-near infrared spectrophotometer (manufactured by Shimadzu Corporation, product name "UV-VIS-NIR SPECTROPHOTOMETER UV-3600"), and the light transmittance (%) at a wavelength of 550 nm was extracted. For the measurement, an accessory large-sample compartment MPC-3100 was used, and the measurement was carried out without using a built-in integrating sphere.

Pellicle films including CNTs are known to have a correlation between their light transmittance at a wavelength of 13.5 nm and light transmittance at a wavelength of 550 nm (see, for example, Marina, Y, et al. "CNT EUV pellicle tunability and performance in a scanner-like environment,". Proc. SPIE 11609, Extreme Ultraviolet (EUV) Lithography XII, 116090Y, (23 March 2021). Figure 4(a).; doi: 10.1117/12.2584519)). Therefore, by evaluating the light transmittance at a wavelength of 550 nm, the light transmittance at a wavelength of 13.5 nm (i.e., EUV transmissivity) can be evaluated. If the light transmittance at a wavelength of 550 nm is 85% or more, for example, a high EUV transmittance (e.g., an EUV transmittance of 94% or more) is readily ensured. The pellicle film according to the exemplary embodiment can be determined to have excellent EUV transmissivity and high EUV transmissivity when the light transmittance at a wavelength of 550 nm is 50% or more.

### Examples 2 to 5 and Comparatives 1 to 4

Pellicle films were prepared in the same manner as in Example 1 except that the dispersion intensity and the mass of the CNTs included in the pellicle films (Mass of CNT in film) were changed as shown in Table 1, and the pore analysis of the pellicle films and the evaluation of transmissivity at a wavelength of 550 nm were performed.

**Table 1**

| | Mass of CNT in film | Dispersion intensity | | Average of pore diameters | Average of Nearest-neighbor centroid-to-centroid distances | Evaluation of transmissivity at 550nm |
|---|---|---|---|---|---|---|
| | | Peripheral speed | Time | | | |
| | (µg/cm²) | (m/s) | (min) | (nm) | (nm) | (%) |
| Ex. 1 | 0.71 | 40 | 25 | 39.7 | 64.5 | 84.7 |
| Ex. 2 | 0.53 | 40 | 25 | 49.1 | 66.1 | 87.8 |
| Ex. 3 | 0.88 | 40 | 20 | 40.2 | 64.3 | 85.2 |
| Ex. 4 | 0.88 | 40 | 15 | 41.4 | 58.2 | 84.1 |
| Ex. 5 | 0.88 | 40 | 10 | 40.9 | 61.3 | 82.9 |
| Comp. 1 | 0.44 | 40 | 25 | 56.3 | 71.7 | 88.2 |
| Comp. 2 | 0.71 | 40 | 10 | 61.2 | 69.7 | 85.8 |
| Comp. 3 | 0.53 | 40 | 10 | 72.1 | 72.9 | 89.3 |
| Comp. 4 | 0.35 | 40 | 25 | 90.8 | 85.9 | 89.9 |

The above results show that pellicle films in which the average of pore diameters is 60 nm or less and the average of nearest-neighbor centroid-to-centroid distances between pores is 70 nm or less are evaluated as excellent in transmissivity at a wavelength of 550 nm. Thus, according to an exemplary embodiment of the invention, a pellicle film ensuring EUV transmissivity regardless of a reduced-size pore structure and a pellicle including the pellicle film can be provided. Furthermore, since the size of the pore structure is reduced according to an exemplary embodiment of the invention, the foreign matter capturing effect is presumably high. The transmissivity at a wavelength of 550 nm of each of Comparatives is superior to that of each of Examples, because the pore structure is relatively large in each of Comparatives. Presumably, the foreign matter capturing effect is low in Comparatives in which the pore structure is relatively large.

### EXPLANATION OF CODES

10...pellicle film, 11...first pellicle film surface, 12...second pellicle film surface, 13...peripheral portion, 30...support, 31...frame, 32...opening, 33...support surface, 100...pellicle.

## Claims

1. A pellicle film having a porous structure,
wherein the pellicle film comprises carbon nanotubes, and
an average of pore diameters of pores is 60 nm or less, and an average of nearest-neighbor centroid-to-centroid distances between the pores is 70 nm or less, the averages being measured at a surface of the porous structure.

2. The pellicle film according to claim 1,
wherein the average of pore diameters is in a range from 20 nm to 60 nm.

3. The pellicle film according to claim 1 or 2,
wherein the average of nearest-neighbor centroid-to-centroid distances is in a range from 40 nm to 70 nm.

4. The pellicle film according to claim 1 or 2,
wherein the carbon nanotubes have a length in a range from 0.1 µm to 1000 µm.

5. The pellicle film according to claim 1 or 2,
wherein the carbon nanotubes have a cross-sectional diameter in a range from 0.2 nm to 50 nm.

6. The pellicle film according to claim 1 or 2,
wherein the pellicle film is a porous structural body formed by deposition of the carbon nanotubes.

7. The pellicle film according to claim 1 or 2,
wherein the pellicle film has a self-standing property.

8. A pellicle comprising:
the pellicle film according to claim 1 or 2; and
a support that has a frame and an opening surrounded by the frame and that supports the pellicle film.
